# DEMANDE DE BREVET EUROPEEN

(11) **EP 4 565 023 A1**
(43) Date de publication de la demande: **04.06.2025**
(21) Numéro de dépôt: 24216424.2
(22) Date de dépôt: 29.11.2024
(51) Int. Cl.: H05K 9/00

(54) **CAGE DE FARADAY**

(30) Priorité: 30.11.2023 FR 2313302
(71) Demandeur: THALES, 92190 Meudon (FR)
(72) Inventeur: LEGEAY, Christophe, 49309 CHOLET (FR); ALCARAS, Alain, 49309 CHOLET (FR)
(74) Mandataire: Atout PI Laplace

(57) **Abrégé**

L'invention concerne une cage de Faraday comportant une ossature (2) gonflable et une toile (3) en tissu électriquement conducteur supportée par l'ossature (2) gonflable, la toile (3) comprenant une portion d'ouverture (30) ayant un bord détachable (300) du reste de la toile (3) de sorte à permettre une ouverture de la cage, ladite portion d'ouverture (30) comprenant sur une face un élément d'assemblage (302), le reste de la toile (3) comprenant sur une face un élément d'assemblage complémentaire (312), l'élément d'assemblage (302) et l'élément d'assemblage complémentaire (312) étant électriquement conducteurs et configurés pour être assemblés l'un à l'autre de sorte à fermer la cage, l'ossature (2) gonflable et la toile (3) en tissu électriquement conducteur étant chacune monobloc.

## Description

L'invention concerne une cage de Faraday. En particulier, l'invention concerne une cage de Faraday transportable pour tester des appareils de petites et moyennes dimensions, du type radios.

Certains appareils, par exemple les radios, nécessitent de tester leur compatibilité électromagnétique CEM, ou EMC pour l'acronyme de "ElectroMagnetic Compatibility" en langue anglaise. Il s'agit de contrôler les rayonnements électromagnétiques émis par les composants de ces appareils et la susceptibilité desdits composants aux rayonnements qu'ils reçoivent ou sont susceptibles de recevoir.

Pour ce faire, ces appareils sont placés dans une cage de Faraday. Les cages de l'art antérieur sont totalement métalliques, volumineuses et lourdes.

De telles solutions ne sont pas pratiques, puisqu'elles sont difficilement déplaçables. Elles ne peuvent être manutentionnées par un seul individu. Leur transport est difficile. En outre, elles occupent de l'espace inutilement lorsqu'elles ne sont pas utilisées.

L'invention vise à proposer une cage de faraday transportable, légère et peu encombrante tout en assurant un bon blindage électromagnétique.

L'invention propose à cet effet une cage de Faraday comportant une ossature gonflable et une toile en tissu électriquement conducteur supportée par l'ossature gonflable, la toile comprenant une portion d'ouverture ayant un bord détachable du reste de la toile de sorte à permettre une ouverture de la cage, ladite portion d'ouverture comprenant sur une face un élément d'assemblage, le reste de la toile comprenant sur une face un élément d'assemblage complémentaire, l'élément d'assemblage et l'élément d'assemblage complémentaire étant électriquement conducteurs et configurés pour être assemblés l'un à l'autre de sorte à fermer la cage, l'ossature gonflable et la toile en tissu électriquement conducteur étant chacune monobloc.

Grâce à sa configuration, la cage de Faraday selon l'invention est facilement transportable et légère. L'ossature gonflable peut être gonflée par une simple pompe, du type pompe à main, rendant la cage très rapide et facile à mettre en place. La cage peut ainsi être utilisée partout où il en est besoin.

Le rangement de la cage est en outre simple puisqu'il suffit de la dégonfler. La cage est ainsi très peu encombrante et peut être pliée et rangée dans un sac une fois dégonflée. Contrairement à l'art antérieur, la cage ne prend pas d'espace inutilement lorsqu'elle n'est pas utilisée.

La portion d'ouverture ayant un bord détachable permet de créer simplement une ouverture afin de pouvoir accéder à l'intérieur de la cage de Faraday. Cela permet de disposer un appareil à tester ou contrôler à l'intérieur de la cage, le retirer ou encore le manipuler.

La présence des élément assemblage et élément d'assemblage complémentaire électriquement conducteurs permet d'assurer l'assemblage électrique et ainsi le blindage électromagnétique.

En étant supportée par l'ossature gonflable, la toile participe le moins possible aux efforts mécaniques de la cage de Faraday. La cage de Faraday selon l'invention s'use ainsi moins vite.

Des caractéristiques préférées particulières commodes de la cage de Faraday selon l'invention sont présentées ci-dessous.

L'un parmi l'élément d'assemblage et l'élément d'assemblage complémentaire comprend des crochets, et l'autre parmi l'élément d'assemblage et l'élément d'assemblage complémentaire comprend des boucles.

La toile présente une épaisseur comprise entre 0,07 millimètre et 0,1 millimètre, de préférence à égale à 0,08 millimètres.

La portion d'ouverture forme tout ou partie d'une face de la toile.

La cage de Faraday a un volume maximal de 1 m³.

La cage de Faraday comprend en outre une plaque configurée pour être assemblée à la toile de manière amovible.

La toile et la plaque comprennent chacune plusieurs orifices, la plaque étant configurée pour être assemblée à la toile par des boulons traversant les orifices.

La plaque comprend des trous configurés pour permettre le passage de câbles.

D'autres particularités et avantages de l'invention apparaîtront encore dans la description ci-après en référence aux dessins annexés, donnés à titre d'exemple non limitatifs :
- la figure 1 représente une cage de Faraday selon un mode de réalisation de l'invention et dans laquelle une portion d'ouverture de la cage est fermée ;
- la figure 2 représente la cage de la Faraday de la figure 1 dans laquelle la portion d'ouverture est ouverte ;
- la figure 3 représente la cage de Faraday de la figure 1 selon un autre angle de vue ; et
- la figure 4 est une vue similaire à la figure 3 et représentant en outre une plaque collectrice de la cage.

Les figures représentent une cage de Faraday 1 selon un mode de réalisation de l'invention.

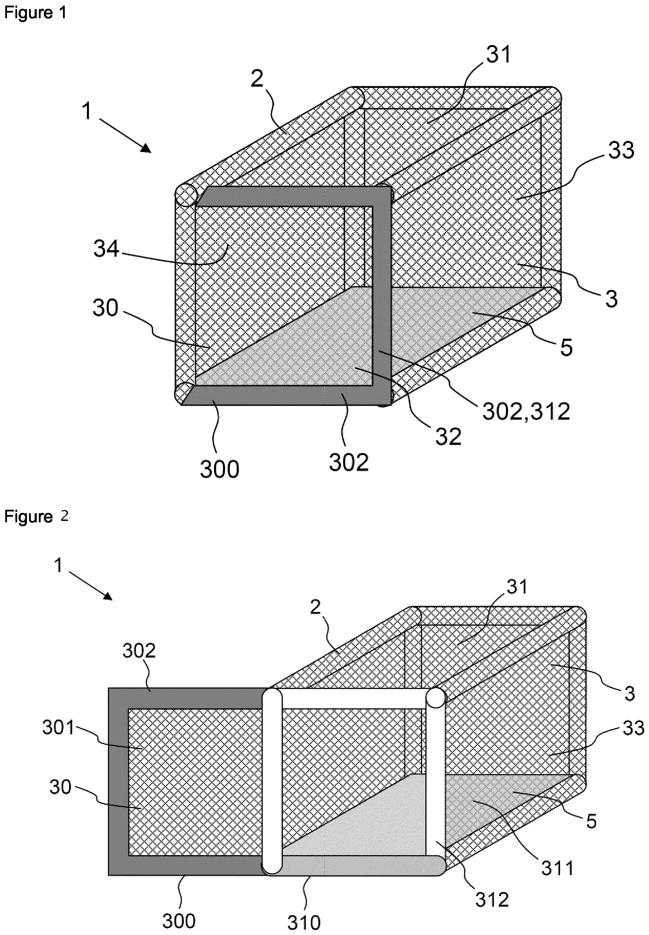

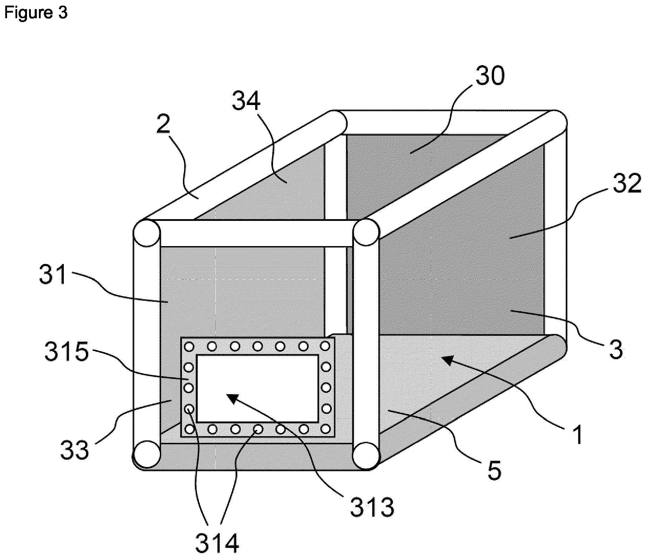

La cage 1 peut être dans une configuration d'emploi ou dans une configuration de transport. La cage 1 est représentée en configuration d'emploi sur les figures 1 à 3.

La cage 1 présente ici une forme parallélépipédique en configuration d'emploi. La forme de la cage peut bien entendu être différente.

La cage 1 présente un volume permettant de loger un appareil de petites et moyennes dimensions (par exemple un poste radio) dont les rayonnements électromagnétiques doivent être contrôlés. La cage 1 présente de préférence un volume maximal de 1 m³.

La cage 1 comporte une ossature 2 gonflable et une toile 3. Le volume de la cage 1 correspond au volume délimité par l'ossature 2.

L'ossature 2 est réalisée en un matériau isolant électrique.

L'ossature 2 est monobloc. En d'autres termes, la cage 1 comprend une seule ossature 2.

L'ossature 2 est gonflée lorsque la cage 1 est dans la configuration d'emploi. L'ossature 2 est dégonflée lorsque la cage 1 est dans la configuration de transport.

La toile 3 est supportée par l'ossature 2. Cela permet à la toile 3 de participer le moins possible aux efforts mécaniques de la cage de Faraday 1. La toile 3 est par exemple cousue à l'ossature 2. La toile 3 est notamment cousue sur l'extérieur de l'ossature 2, ou autrement dit à une face externe de l'ossature 2.

La toile 3 est en tissu électriquement conducteur. La toile 3 est réalisée en un matériau ayant une haute conductivité électrique, notamment au moins égale à 1.10⁷ S/m. Par exemple, la toile 3 a une conductivité électrique égale à 3.10⁷ S/m.

La toile 3 est par exemple métallique ou en alliage métallique. Dans un exemple de réalisation, la toile 3 est réalisée en un alliage comprenant de l'argent, du cuivre et/ou du nickel.

L'épaisseur de la toile 3 est définie par un compromis entre une activité de blindage en basse fréquence et un poids acceptable, i.e. pas trop lourd, pour la toile 3. La toile 3 doit être en effet la plus légère possible afin de faciliter la manipulation et le transport de la cage 1, tout en permettant d'atteindre les objectifs de blindage souhaités aux fréquences d'intérêt.

La toile 3 présente une épaisseur comprise entre 0,07 millimètres et 0,1 millimètres, de préférence égale à 0,08 millimètres.

La configuration de la toile 3, notamment par le choix du matériau électriquement conducteur ayant une haute conductivité et l'optimisation de l'épaisseur de la toile 3, permet d'obtenir une efficacité de blindage supérieure à 50 dB pour des fréquences de 1MHz à 1GHz.

Selon un mode de réalisation spécifique permettant d'obtenir l'efficacité de blindage visée, notamment supérieure à 50 dB de 1MHz à 1GHz, la toile 3 est en alliage comprenant de l'argent, du cuivre et du nickel, et l'épaisseur de la toile 3 est de 0,08 millimètres.

La toile 3 est monobloc. En d'autres termes, la cage comprend une seule toile 3.

La toile 3 comprend une portion d'ouverture 30. La portion d'ouverture 30 forme tout ou partie d'une face de la toile 3. La portion d'ouverture 30 forme dans l'exemple illustré une face entière de la toile 3. La portion d'ouverture 30 forme ainsi une face entière de la cage lorsque celle-ci est dans la configuration d'emploi. La face entière est ici également appelée face avant 32.

Dans d'autres exemples non limitatifs, la portion d'ouverture 30 peut former une autre face de la toile 3 que celle représentée (ici face avant 32), former une portion uniquement d'une face de la toile 3 ou s'étendre sur plusieurs faces de la toile 3.

Selon un autre exemple de réalisation, la toile 3 peut comprendre plusieurs portions d'ouverture.

La portion d'ouverture 30 comprend un bord détachable 300 du reste de la toile 3 (reste de la toile étant ici nommé portion restante 31) de sorte à permettre une ouverture de la cage 1. La portion d'ouverture 30 constitue ainsi la portion de la toile 3 qui peut être détachée de la portion restante 31 afin de former une ouverture dans la cage 1. Lorsque les bords de la portion d'ouverture 30 sont détachés de la portion restante 31, comme visible sur la figure 2 représentant la portion d'ouverture 30 ouverte, il est possible d'accéder à l'intérieur de la cage 1.

Le bord détachable 300 forme sur l'exemple représenté trois arêtes de la toile 3, en particulier trois arêtes de la face avant 32.

Le bord détachable 300 peut être formé ailleurs sur la toile 3, et/ou présenter d'autres dimensions et forme. Le bord détachable 300 peut former une ou plusieurs arêtes de la toile 3, entièrement ou en partie. Le bord détachable 300 peut être formé ailleurs que sur l'une des arêtes de la toile 3.

La portion restante 31 comprend un bord, dit bord fixe 310. Le bord fixe 310 de la portion restante 31 présente la même forme et les mêmes dimensions que le bord détachable 300 de la portion d'ouverture 30. Le bord fixe 310 et le bord détachable 300 sont vis-à-vis l'un de l'autre lorsque la cage 1 est dans la configuration d'emploi.

La portion d'ouverture 30 présente des dimensions permettant l'insertion et le retrait de la cage 1 de l'appareil à tester. La portion d'ouverture 30 présente par exemple une surface au moins égale à 70% ou 80% de la surface de la face avant 32.

La portion d'ouverture 30 comprend sur une face, dite face d'assemblage 301, un élément d'assemblage 302. La portion restante 31 de la toile 3 comprend sur une face, dite face d'assemblage complémentaire 311, un élément d'assemblage complémentaire 312 (visibles sur la figure 2). La face d'assemblage 301 peut être une face interne ou une face externe de la portion d'ouverture 30. La face d'assemblage complémentaire 311 peut être une face interne ou une face externe de la portion restante 31.

Lorsque la face d'assemblage 301 est la face interne de la portion d'ouverture 30, la face d'assemblage complémentaire 311 est la face externe de la portion restante 31. Lorsque la face d'assemblage 301 est la face externe de la portion d'ouverture 30, la face d'assemblage complémentaire 311 est la face interne de la portion restante 31.

L'élément d'assemblage 302 et l'élément d'assemblage complémentaire 312 sont électriquement conducteurs. L'élément d'assemblage 302 est assemblé à l'élément d'assemblage complémentaire 312 de sorte à connecter électriquement la portion d'ouverture 30 et la portion restante 31. Autrement dit, l'assemblage des élément d'assemblage 302 et élément d'assemblage complémentaire 312 électriquement conducteurs entre eux permet d'assurer la continuité électrique, améliorant ainsi la performance électromagnétique de la cage de Faraday 1.

Une telle configuration permet un bon assemblage électrique par recouvrement des portion d'ouverture 30 et portion restante 31 au niveau des élément d'assemblage 302 et élément d'assemblage complémentaire 312.

L'élément d'assemblage 302 s'étend à proximité du bord détachable 300 et l'élément d'assemblage complémentaire 312 s'étendent à proximité du bord fixe 310 (visible sur la figure 2). L'élément d'assemblage 302 s'étend ici tout le long du bord détachable 300 et l'élément d'assemblage complémentaire 312 s'étend ici tout le long du bord fixe 310. Autrement dit, l'élément d'assemblage 302, l'élément d'assemblage complémentaire 312, le bord détachable 300 et le bord fixe 310 présentent une même longueur. Une telle configuration permet d'assurer la continuité électrique.

Par exemple, l'un parmi l'élément d'assemblage 302 et l'élement d'assemblage complémentaire comprend des crochets. L'autre parmi l'élément d'assemblage 302 et l'élement d'assemblage complémentaire comprend des boucles. Autrement dit, l'élément d'assemblage 302 et l'élément d'assemblage complémentaire 312 forment une fermeture autoagrippante, également connue sous le nom velcro d'après le nom de la marque Velcro. L'élément d'assemblage 302 et l'élément d'assemblage complémentaire 312 sont assemblés en étant disposés l'un sur l'autre.

Selon un exemple de réalisation, l'élément d'assemblage 302 et l'élément d'assemblage complémentaire 312 comprennent par exemple chacun deux portions, dites portions d'assemblage et portions d'assemblage complémentaires. Chaque portion d'assemblage est configurée pour être assemblée avec une portion d'assemblage complémentaire respective. Bien entendu, le nombre de portions d'assemblage et de portions d'assemblage complémentaires peut également être différent.

La largeur de l'élément d'assemblage 302 et l'élément d'assemblage complémentaire 312 est définie pour améliorer également la continuité électrique.

L'élément d'assemblage 302 et l'élément d'assemblage complémentaire 312 présentent chacun une largeur comprise entre 3 centimètres et 5 centimètres, de préférence égale à 5 centimètres.

La cage 1 comprend en outre une fenêtre 313. La fenêtre 313 est ici formée sur une face arrière 33 de la cage. La face arrière 33 est opposée et ici parallèle à la face avant 32. Alternativement, la fenêtre 313 peut être formée sur une face latérale 34 de la cage 1.

La fenêtre 313 présente ici une forme rectangulaire mais qui peut être modifiée en fonction des besoins.

La fenêtre 313 est pré-percée, i.e. formée directement dans la toile 3 avant montage de la cage 1 pour son emploi.

La toile 3 comprend plusieurs orifices 314. La toile 3 comprend ici vingt orifices 314, mais ce nombre peut bien entendu être différent.

Les orifices 314 s'étendent autour de la fenêtre 313. Les orifices 314 sont arrangés ici selon un agencement rectangulaire. L'agencement peut être différent, polygonal ou non. L'agencement des orifices 314 dépend notamment de la forme de la fenêtre 313.

Les orifices 314 sont ici formés sur la face arrière 33 de la cage 1. Alternativement, en particulier lorsque la fenêtre 313 est formée dans une face latérale 34 de la cage 1, les orifices 314 sont formés sur ladite face latérale 34 de la cage 1.

Les orifices 314 sont configurés pour recevoir chacun un boulon. Chaque orifice 314 est dimensionné en fonction de la taille et du type de boulon visé.

Les orifices 314 présentent ici une forme circulaire mais peuvent bien entendu présenter une forme différente.

Les orifices 314 sont pré-percés.

La toile 3 comprend de préférence une portion renforcée 315. La portion renforcée 315 s'étend autour des orifices 314. La portion renforcée 315 forme ici un cadre rectangulaire. La portion renforcée 315 présente par exemple une épaisseur plus importante que le reste de la toile 3.

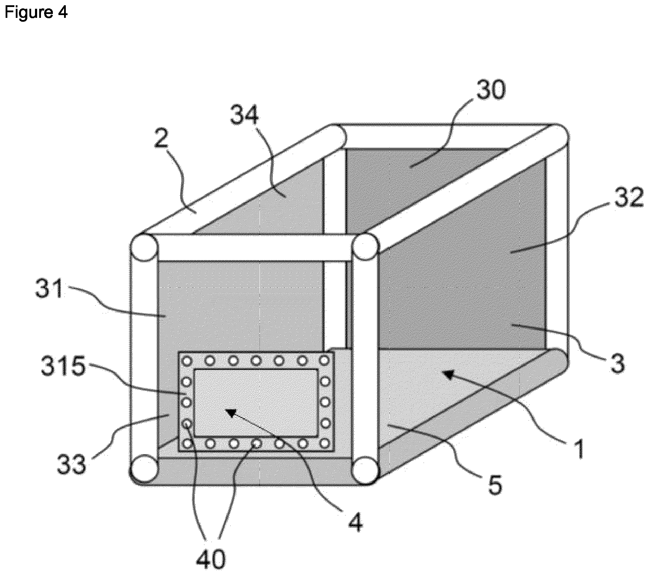

La cage de Faraday 1 comporte en outre une plaque 4 (visible sur la figure 4), aussi appelée plaque collectrice, configurée pour être assemblée de manière amovible à la toile 3.

La plaque 4 est par exemple configurée pour être assemblée à la toile 3 par des boulons. La plaque 4 comprend des orifices 40 configurés pour permettre le passage des boulons. La plaque 4 et la toile 3 peuvent comprendre le même nombre d'orifices 40, 314. Les orifices 40 de la plaque 4 et les orifices 314 de la toile 3 présentent les mêmes dimensions et forme. Au moins une partie des orifices 40 de la plaque 4 et des orifices 314 de la toile 3 se trouvent en vis-à-vis lorsque la plaque 4 est assemblée à la toile 3. Les boulons traversent les orifices 40 de la plaque 4 et les orifices 314 de la toile 3, et permettent l'assemblage amovible de la plaque 4 avec la toile 3.

La plaque 4 présente une forme et des dimensions permettant d'obturer la fenêtre 313 de la toile 3 lorsque la plaque 4 est assemblée à la toile 3. La plaque 4 est assemblée sur la face comprenant les orifices 314 et la fenêtre 313.

Les orifices 314 et la fenêtre 313 de la toile 3 étant pré-percés, cela permet d'assembler la plaque 4 à la toile 3 sans endommager la toile 3.

La plaque 4 étant assemblée à la toile 3 de manière amovible, cela permet de changer facilement de plaque 4, en fonction des besoins et notamment de l'appareil à tester.

Les orifices 314 et la fenêtre 313 de la toile 3 sont de préférence formés proche du fond de la cage 1. Les orifices 314 et la fenêtre 313 de la toile 3 sont notamment formés le plus proche possible du fond de la cage 1. Cela permet d'éviter (ou du moins limiter) que la toile 3 ne supporte le poids de la plaque 4. Cela permet notamment d'éviter que la toile 3 ne supporte les forces verticales exercées par la plaque 4.

La portion renforcée 315 quant à elle forme une sécurité supplémentaire pour éviter la déchirure de la toile 3 à cause de la plaque 4. La portion renforcée 315 permet de reprendre les forces latérales exercées par la plaque 4.

La plaque 4 comprend en outre des trous (non représentés sur les figures) configurés pour permettre le passage de câbles. La forme, le nombre, les dimensions et la disposition des trous varient en fonction de l'appareil à tester à introduire dans la cage 1. La plaque 4 étant assemblée de manière amovible à la toile 3, cela permet de changer de plaque 4 facilement en fonction des besoins et notamment de l'appareil à tester. Un utilisateur peut ainsi disposer de diverses plaques 4, et assembler à la toile 3 celle qui lui convient en fonction de ses besoins.

La plaque 4 permet de faire traverser des câbles électriques dans la cage 1 sans en dégrader le blindage. Autrement dit, la plaque 4 permet de faire passer les câbles à travers la cage 1 tout en permettant de tester l'appareil disposé à l'intérieur de la cage. Les câbles permettent notamment d'alimenter l'appareil à l'intérieur de la cage, le commander, ou le contrôler.

La plaque 4 est ici assemblée sur la face arrière 33 de la toile 3 comprenant la fenêtre 313 et les orifices 314. L'assemblage de la plaque 4 à l'arrière de la cage permet de connecter plus facilement les câbles aux appareils introduits dans la cage et dont les connectiques se trouvent généralement à l'arrière des appareils.

La cage de Faraday 1 peut comporter en outre un tapis de sol 5 ou plancher.

Le tapis de sol 5 est adapté à être disposé sur une face de fond de la toile 3 et s'étend horizontalement lorsque la cage 1 est en configuration d'emploi. Le tapis de sol 5 permet ainsi de former une protection physique pour la toile 3, et évite ou limite son endommagement. Le tapis de sol 5 permet en effet de protéger la face de fond de la toile 3 sur laquelle serait disposé un appareil dont il faut contrôler les radiations électromagnétiques.

Le tapis de sol 5 peut être réalisé dans le même matériau que l'ossature 2 gonflable. Le tapis de sol 5 peut également être gonflable.

Le montage de la cage de Faraday 1 est réalisé de la manière suivante.

La cage de Faraday 1, en configuration de transport, est disposée sur le sol. Les élément d'assemblage 302 et élément d'assemblage complémentaire 312 sont assemblés entre eux. Puis l'ossature 2 est gonflée. La cage 1 se déploie petit à petit.

S'il y en a un, le tapis de sol 5 peut être disposé sur la face de fond de la toile 3 avant ou après gonflage de l'ossature 2. En particulier, lorsqu'il est gonflable, le tapis de sol 5 dégonflé peut être disposé sur la face de fond de la toile 3 avant gonflage de l'ossature 2. Le tapis de sol 5 est gonflé après gonflage de l'ossature 2.

Afin de passer de la configuration d'emploi à la configuration de transport, l'ossature 2 est dégonflée, et éventuellement le tapis de sol 5 est dégonflé (si celui-ci est gonflable).

La cage en configuration de transport peut être pliée, et est ainsi très facilement transportable et peu encombrante.

La cage de Faraday selon l'invention présente de nombreux avantages. Elle est transportable, réduisant les problèmes logistiques et permettant son utilisation n'importe où. Elle peut être facilement montée et démontée.

Grâce à la portion d'ouverture et sa configuration, l'invention permet de créer une porte pour la cage de Faraday tout en maintenant une très bonne continuité électrique.

Lors du montage de la cage, il n'est pas nécessaire d'assembler plusieurs éléments entre eux pour former la cage. L'ossature étant monobloc, elle ne nécessite pas d'assemblage de plusieurs éléments (par exemple de plusieurs ossatures) avant de pouvoir la gonfler. De même, la toile étant monobloc, elle ne nécessite pas d'assemblage (par exemple de plusieurs toiles) lors du montage de la cage et notamment son déploiement en configuration d'emploi. La toile étant en outre déjà assemblée à l'ossature gonflable, ici cousue à l'ossature, elles forment un seul bloc. Par simple gonflage de l'ossature, la cage est déployée en configuration d'emploi.

## Revendications

1. Cage de Faraday comportant une ossature (2) gonflable et une toile (3) en tissu électriquement conducteur supportée par l'ossature (2) gonflable, la toile (3) comprenant une portion d'ouverture (30) ayant un bord détachable (300) du reste de la toile (3) de sorte à permettre une ouverture de la cage, ladite portion d'ouverture (30) comprenant sur une face un élément d'assemblage (302), le reste de la toile (3) comprenant sur une face un élément d'assemblage complémentaire (312), l'élément d'assemblage (302) et l'élément d'assemblage complémentaire (312) étant électriquement conducteurs et configurés pour être assemblés l'un à l'autre de sorte à fermer la cage, l'ossature (2) gonflable et la toile (3) en tissu électriquement conducteur étant chacune monobloc.

2. Cage de Faraday selon la revendication 1, dans laquelle l'un parmi l'élément d'assemblage (302) et l'élément d'assemblage complémentaire (312) comprend des crochets, et l'autre parmi l'élément d'assemblage (302) et l'élément d'assemblage complémentaire (312) comprend des boucles.

3. Cage de Faraday selon la revendication 1 ou la revendication 2, dans laquelle la toile (3) présente une épaisseur comprise entre 0,07 millimètre et 0,1 millimètre, de préférence à égale à 0,08 millimètres.

4. Cage de Faraday selon l'une des revendications 1 à 3, dans laquelle la portion d'ouverture (30) forme tout ou partie d'une face de la toile (3).

5. Cage de Faraday selon l'une des revendications 1 à 4, ayant un volume maximal de 1 m³.

6. Cage de Faraday selon l'une des revendications 1 à 5, comprenant en outre une plaque (4) configurée pour être assemblée à la toile (3) de manière amovible.

7. Cage de Faraday selon la revendication 6, dans laquelle la toile (3) et la plaque (4) comprennent chacune plusieurs orifices (314, 40), la plaque (4) étant configurée pour être assemblée à la toile (3) par des boulons traversant les orifices (314, 40).

8. Cage de Faraday selon la revendication 6 ou la revendication 7, dans laquelle la plaque (4) comprend des trous configurés pour permettre le passage de câbles.
